# FASCICULE DE BREVET EUROPEEN

(11) **EP 0 932 046 B1**
(45) Date de publication et mention de la délivrance du brevet: **21.03.2007**
(21) Numéro de dépôt: 99400146.9
(22) Date de dépôt: 22.01.1999
(51) Int. Cl.: G01R 13/40, G01D 7/00

(54) **Système d'affichage de la valeur d'un signal**
System zur Anzeige des Werts eines Signals
System for displaying the value of a signal

(30) Priorité: 26.01.1998 FR 9800772
(43) Date de publication de la demande: 28.07.1999
(73) Titulaire: ALCATEL, 75008 Paris (FR)
(72) Inventeur: Abbe, Yvan, 74000 Annecy (FR)
(74) Mandataire: Lamoureux, Bernard

(56) Documents cités:
- FR-A- 2 438 885
- PATENT ABSTRACTS OF JAPAN vol. 007, no. 216 (P-225), 24 septembre 1983 & JP 58 108407 A (NIPPON DENSO KK), 28 juin 1983

## Description

La présente invention concerne un système d'affichage de la valeur d'un signal dont la dynamique s'étend sur plusieurs puissances de dix.

L'invention s'applique, par exemple, dans la mesure d'un flux de fuite par un détecteur de fuite où la sensibilité de l'appareil peut être très élevée, et peut, par exemple, déceler des fuites de quelques 10⁻¹⁰ mbars x litres/secondes. Un tel appareil doit donc avoir un système d'affichage permettant une lecture précise et aisée de la valeur de la fuite dans toute l'étendue de la gamme de mesure depuis 1 mbar x litre/seconde jusqu'aux fuites très faibles de la valeur indiquée ci-dessus.

L'invention s'applique bien entendu dans n'importe quel domaine et trouve son intérêt chaque fois que l'étendue de la mesure est grande et que l'on désire une bonne précision et facilité de la lecture.

Un système d'affichage actuellement utilisé dans ce cas pour les détecteurs de fuite comprend deux rampes rectilignes, parallèles dont l'une est graduée selon les différentes puissances négatives de dix et l'autre de 0 à 10 et indiquant la valeur du multiple de la puissance négative de dix affichée sur la première rampe.

Un tel système d'affichage présente l'inconvénient de nécessiter d'observer successivement deux rampes d'affichage et, en cas d'évolution rapide de la valeur du signal sur une étendue couvrant plusieurs puissances de dix, la rampe graduée de 0 à 10 monte très rapidement et plusieurs fois de suite en repartant à chaque fois de 0, provoquant un effet de clignotement désagréable.

On connaît aussi, du document FR-2 438 885 A, un système d'affichage à au moins trois colonnes de dix sources lumineuses correspondant respectivement aux centaines, dizaines et unités. On retrouve le même inconvénient d'un clignotement désagréable de la colonne des unités.

Un autre système connu d'affichage comporte une fenêtre où est affichée la valeur grossière du signal indiquant la gamme de puissance de dix de la valeur du signal, et une rampe circulaire pour l'indication du multiple de 1 à 10 de cette puissance de dix.

Ici aussi, l'observateur doit regarder deux emplacements distincts, et la rotation rapide de l'index de la rampe circulaire en cas de grande variation de la valeur du signal est également assez déroutante.

Le document JP-58108407 A décrit un dispositif d'affichage de la vitesse d'un véhicule. Ce dispositif contient les caractéristiques du préambule de la revendication 1. 200 zones correspondant chacune à une même unité de vitesse, sont disposées en un empilement de 10 secteurs de couronne ayant chacun 20 zones.

L'invention a ainsi pour but de pallier ces inconvénients et a pour objet un système d'affichage de la valeur d'un signal dont la dynamique s'étend sur plusieurs puissances de dix, comprenant un écran de visualisation ayant une forme géométrique déterminée divisée en zones et comportant des moyens pour remplir les zones en fonction de la valeur du signal, la valeur du signal étant lue en repérant l'emplacement de la dernière zone remplie et chaque zone étant repérable par un système de deux coordonnées, la première coordonnée repérant un des groupes de zones et la deuxième coordonnée repérant un des niveaux de zones dans chaque groupe, caractérisé en ce que les différents groupes sont gradués de 1 à 9 et les niveaux de zones sont gradués selon différentes puissances de dix, et en ce que la valeur du signal est lue en exprimant d'abord le nombre de 1 à 9 correspondant au groupe de la dernière zone remplie puis en le multipliant par la puissance de dix correspondante au niveau de la dernière zone remplie

Selon une première réalisation, ladite forme géométrique déterminée, divisée en zones, est un parallélogramme quadrillé, le quadrillage représentant lesdites zones repérées selon deux côtés adjacents par ledit système de deux coordonnées.

De préférence, le parallélogramme est rectangle.

Selon une seconde réalisation, ladite forme géométrique déterminée, divisée en zones, est un cercle divisé en secteurs lesdits secteurs définissant lesdits groupes de zones, et en une pluralité de couronnes circulaires concentriques, autour d'un cercle central, lesdites couronnes et le cercle central définissant lesdits niveaux.

L'invention va maintenant être décrite en se référant au dessin annexé dans lequel :
La figure 1 montre un système d'affichage selon l'invention.
La figure 2 montre une variante de l'invention.
La figure 3 montre un exemple de réalisation de l'invention utilisant des diodes èlectro-luminescentes comme moyen de remplissage visuel de la surface.

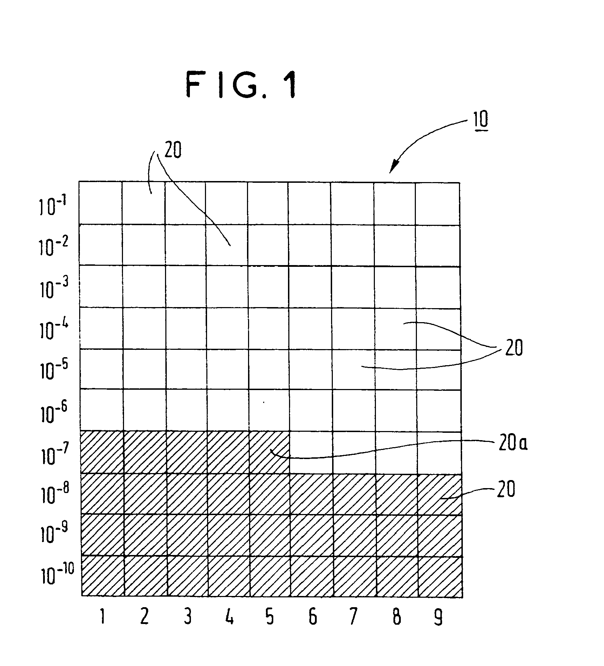

En se référant à la figure 1, on voit ainsi un système d'affichage d'un signal dont la dynamique s'étend sur dix décades. Un tel système est particulièrement intéressant pour l'écran d'affichage de la fuite d'un détecteur de fuite à gaz traceur.

Le système d'affichage est ici constitué d'un écran qui comprend un espace de visualisation de forme rectangulaire 10 divisé en zones 20 selon un quadrillage.

Les zones 20 sont repérées par un système de deux coordonnées dont l'un repère un des groupes de zones 20 constituant des colonnes de zones du quadrillage, graduées de 1 à 9, et la deuxième coordonnée repère un des niveaux de zones 20 constituant des lignes de zones du quadrillage qui sont graduées de 10⁻¹⁰ à 10⁻¹.

C'est le remplissage, sous forme de coloration ou d'éclairage, des zones 20 de la surface du rectangle 1 qui représente la valeur du signal. Cette valeur est lue en exprimant les coordonnées de l'emplacement de la dernière zone 20 remplie, repérée ici 20a.

Dans l'exemple de la figure 1, la valeur du signal est 5 x 10⁻⁷. S'il s'agit de l'affichage de la valeur du signal d'un flux de fuite mesuré par un détecteur de fuite, cette valeur est donc de 5 x 10⁻⁷ mbar x litre/seconde.

Ainsi, en cas de variation rapide du signal, à la hausse ou à la baisse, les lignes se "remplissent" ou se "vident" rapidement, mais il n'y a aucun effet de clignotement.

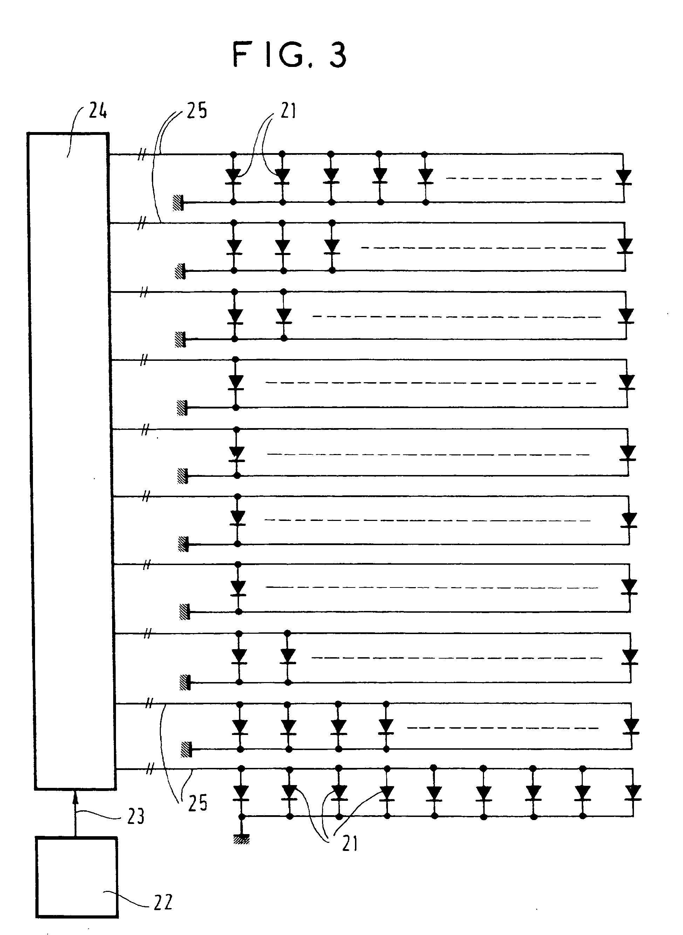

La figure 3 donne un exemple de réalisation où le remplissage de la surface est effectué par des diodes électro-luminescentes 21. Dans l'exemple de la figure 1 il y a 9 x 10 = 90 zones 20, on a donc 90 diodes électro-luminescentes 21.

Sur la figure 3, on a ainsi un détecteur de fuite 22 dont le signal de sortie 23 alimente un système 24 de commande d'allumage des diodes 21.

La représentation est schématique et chaque bus d'alimentation 25 de chaque ligne de diodes 21 comprend neuf fils alimentant chacun une diode 21.

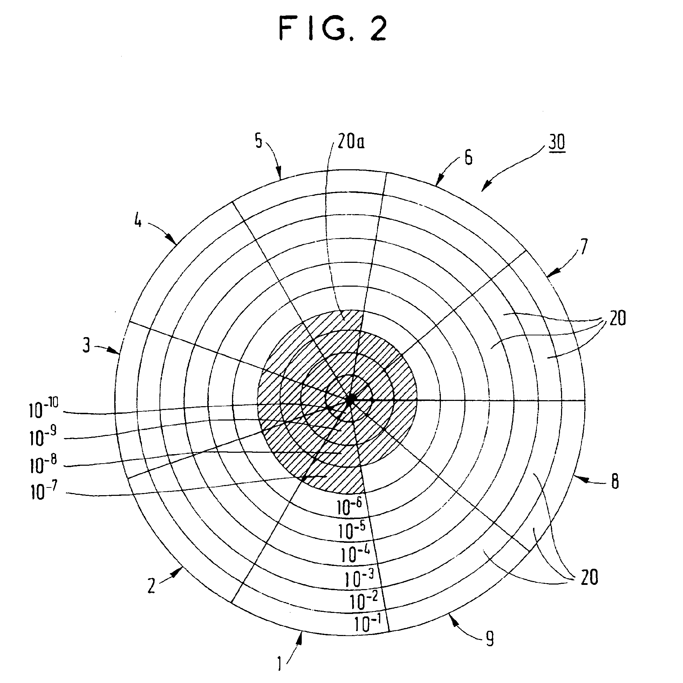

La figure 2 est une variante dans laquelle l'écran de visualisation est un cercle 30 divisé en neuf secteurs gradués de 1 à 9 définissant chacun un groupe de zones 20. Chaque groupe de zones contient dix zones 20 constituant dix niveaux de zones 20. Ces niveaux sont définis par un cercle central représentant le plus faible niveau : 10⁻¹⁰ et par neuf couronnes circulaires concentriques représentant successivement, du centre vers la périphérie, les niveaux 10⁻⁹, 10⁻⁸..... 10⁻¹.

Comme dans l'exemple de la figure 1, la valeur du signal est donnée par les coordonnées de l'emplacement de la dernière zone 20 remplie, repérée ici 20a, dans le sens de l'accroissement du remplissement de la surface. La valeur du signal est donc : 5 x 10⁻⁷ puisque la zone 20a est située dans le groupe 5 de niveau 10⁻⁷.

Ici encore, une variation rapide du signal, selon son sens, se traduit par une augmentation ou une diminution de la quantité de surface éclairée et la lecture est aisée et précise.

## Revendications

1. Système d'affichage de la valeur d'un signal dont la dynamique s'étend sur plusieurs puissances de dix, comprenant un écran de visualisation ayant une forme géométrique déterminée (10, 30), divisée en zones (20), et comportant des moyens (21) pour remplir les zones (20) en fonction de la valeur du signal, la valeur du signal étant lue en repérant l'emplacement de la dernière zone remplie (20a) et chaque zone étant repérable par un système de deux coordonnées, la première coordonnée repérant un des groupes de zones et la deuxième coordonnée repérant un des niveaux de zones dans chaque groupe **caractérisé en ce que** les différents groupes sont gradués de a 9 et les niveaux de zones sont gradués selon différentes puissances de dix, et **en ce que** la valeur du signal est lue en exprimant d'abord le nombre de 1 à 9 correspondant au groupe de la dernière zone remplie (20a), puis en le multipliant par la puissance de dix correspondante au niveau de la dernière zone remplie (20a).

2. Système d'affichage selon la revendication 1, **caractérisé en ce que** ladite forme géométrique déterminée, divisée en zones, est un parallélogramme quadrillé, le quadrillage représentant lesdites zones (20) repérées selon deux côtés adjacents par ledit système de deux coordonnées.

3. Système selon la revendication 2, **caractérisé en ce que** le parallélogramme (10) est rectangle.

4. Système selon la revendication 1, **caractérisé en ce que** ladite forme géométrique déterminée, divisée en zones, est un cercle (30) divisé en secteurs de 1 à 9. lesdits secteurs définissant lesdits groupes de zones, et en une pluralité de couronnes circulaires concentriques, autour d'un cercle central, lesdites couronnes et le cercle central définissant lesdits niveaux.

5. Système selon l'une des revendications 1 à 4, **caractérisé en ce que** lesdits moyens pour remplir les zones (20) sont des moyens d'éclairage (21).

## Claims

1. A system for displaying the value of a signal whose dynamic range extends over several powers of ten, the system comprising a display screen of predetermined geometrical shape (10, 30) subdivided into zones (20), and further comprises means (21) for filling the zones (20) as a function of the value of the signal, the value of the signal being read by identifying the location of the last-filled zone (20a), and each zone being identifiable in a two-coordinate system, the first coordinate identifying one of the groups of zones, and the second coordinate identifying one of the zone levels within each group, the system being **characterized in that** the various groups are graduated from 1 to 9, and the zone levels are graduated with various powers of ten, and **in that** the value of the signal is read by expressing firstly the number from 1 to 9 corresponding to the group of the last-filled zone (20a), and then multiplying it by the power of ten corresponding to the level of the last-filled zone (20a).

2. A display system according to claim 1, **characterized in that** said determined geometrical shape subdivided into zones is a grided parallelogram, the grid representing said zones (20) which are identified along two adjacent sides by said two-coordinate system.

3. A system according to claim 2, **characterized in that** the parallelogram (10) is a rectangle.

4. A system according to claim 1, **characterized in that** said determined geometrical shape subdivided into zones is a circle (30) subdivided into sectors from 1 to 9, said sectors defining said zone groups, and into a plurality of concentric circular rings around a central circle, said rings and the central circle defining said levels.

5. A system according to any one of claims 1 to 4, **characterized in that** said means for filling the zones (20) are light-emitting means (21).

## Patentansprüche

1. System zur Anzeige des Werts eines Signals, dessen Dynamik sich über mehrere Zehnerpotenzen erstreckt, beinhaltend ein Display, das eine bestimmte geometrische Form (10, 30) hat, in Bereiche (20) eingeteilt ist, und Mittel (21) enthält, um die Bereiche (20) in Abhängigkeit vom Wert des Signals zu füllen, wobei der Wert des Signals abgelesen wird, indem der Platz des letzten ausgefüllten Bereichs (20a) markiert wird und jeder Bereich durch ein System aus zwei Koordinaten markiert werden kann, wobei die erste Koordinate eine der Bereichs gruppen markiert [die verschiedenen Gruppen sind von 1 bis 9 eingeteilt] und die zweite Koordinate eine der Bereichsebenen in jeder Gruppe markiert, wobei die Bereichsebenen entsprechend verschiedenen Zehnerpotenzen eingeteilt sind, **dadurch gekennzeichnet, dass** der Wert des Signals so abgelesen wird, dass zunächst die Zahl von 1 bis 9 ausgedrückt wird, die der Gruppe des letzten ausgefüllten Bereichs (20a) entspricht, dann durch dessen Multiplikation mit der Zehnerpotenz, die der Ebene des letzten ausgefüllten Bereichs (20a) entspricht.

2. Anzeigesystem gemäß Anspruch 1, **dadurch gekennzeichnet, dass** diese bestimmte geometrische Form, die in Bereiche eingeteilt ist, ein schachbrettartiges Parallelogramm ist, wobei das Würfelmuster diese Bereiche (20) darstellt, welche gemäß zwei angrenzenden Seiten von diesem Zwei-Koordinaten-System markiert werden.

3. System gemäß Anspruch 2, **dadurch gekennzeichnet, dass** das Parallelogramm (10) rechtwinklig ist.

4. System gemäß Anspruch 1, **dadurch gekennzeichnet, dass** diese bestimmte geometrische Form, die in Bereiche eingeteilt ist, ein Kreis (30) ist, der aufgeteilt ist in Sektoren von 1 bis 9, wobei diese Sektoren diese Bereichsgruppen definieren, und aufgeteilt ist in eine Vielzahl von runden konzentrischen Kränzen um einen Mittelkreis herum, wobei diese Kränze und der Mittelkreis diese Ebenen definieren.

5. System gemäß einem der Ansprüche 1 bis 4, **dadurch gekennzeichnet, dass** diese Mittel zum Ausfüllen der Bereiche (20) Beleuchtungsmittel (21) sind.
